# EUROPÄISCHE PATENTSCHRIFT

(11) **EP 3 251 478 B1**
(45) Veröffentlichungstag und Bekanntmachung des Hinweises auf die Patenterteilung: **12.05.2021**
(21) Anmeldenummer: 16704548.3
(22) Anmeldetag: 27.01.2016
(51) Int. Cl.: H05K 7/20, F04D 25/16, F04D 27/00, F24F 7/007

(54) **LÜFTERANORDNUNG UND ZUGEHÖRIGER SCHALTSCHRANK**
FAN ARRANGEMENT AND CORRESPONDING ELECTRICAL ENCLOSURE
ENSEMBLE VENTILATEUR ET ARMOIRE ÉLECTRIQUE CORRESPONDANTE

(30) Priorität: 28.01.2015 DE 102015201478
(43) Veröffentlichungstag der Anmeldung: 06.12.2017
(73) Patentinhaber: FRAMATOME, 92400 Courbevoie (FR)
(72) Erfinder: KAUN, Norman, 91056 Erlangen (DE)
(74) Vertreter: Lavoix
(86) Internationale Anmeldenummer: PCT/EP2016/051726
(87) Internationale Veröffentlichungsnummer: WO 2016/120343

(56) Entgegenhaltungen:
- US-A1- 2011 259 550

## Beschreibung

Die Erfindung betrifft eine Lüfteranordnung mit den Merkmalen des Oberbegriffes von Anspruch 1. Sie betrifft mithin eine Lüfteranordnung mit einer Mehrzahl von parallel zueinander angeordneten und zur Erzeugung eines Luftstromes entlang einer gemeinsamen Hauptströmungsrichtung ausgelegten Ventilatoren, wobei
- jedem Ventilator mindestens ein Strömungskanal zugeordnet ist,
- der jeweilige Strömungskanal mit einer Klappe versehen ist, die zwischen einer Öffnungsstellung und einer Schließstellung schwenkbar ist, und
- die jeweilige Klappe derart konstruiert und im Strömungskanal angeordnet ist, dass sie durch den Luftstrom in der Öffnungsstellung gehalten oder unterstützt wird und durch einen dem Luftstrom entgegen gerichteten Rückstrom in die Schließstellung gebracht wird
- die jeweilige Klappe derart konstruiert ist, dass sie im strömungslosen Zustand durch ihr Eigengewicht in die Öffnungsstellung gebracht wird,
- die Hauptströmungsrichtung im Wesentlichen vertikal von unten nach oben ausgerichtet ist.

Eine derartige Lüfteranordnung ist aus US 2011/0259550 A1 bekannt. Die Erfindung betrifft ferner einen Schaltschrank mit einer derartigen Lüfteranordnung.

Für die Abfuhr der Verlustleistung von elektronischen Baugruppen, die üblicherweise in Schaltschränken angeordnet sind, werden Lüfter eingesetzt. Die Lüfter werden auch als Ventilatoren bezeichnet. Häufig werden dazu mehrere Lüfter parallel oder redundant zueinander betrieben. Sind mehrere Lüfter in einer Ebene angeordnet, kann es bei Ausfall eines der Lüfter zu einem strömungstechnischen Kurzschluss kommen.

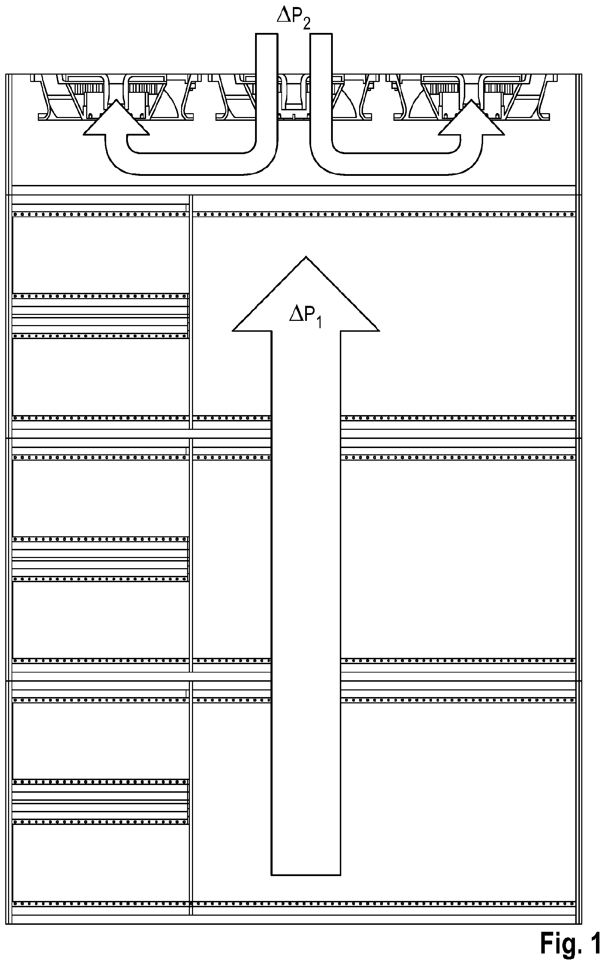

Zur Veranschaulichung dieses Phänomens wird auf FIG. 1 verwiesen: Dort sind in die obere Deckenplatte eines Schaltschrankes drei gleichartige Lüfter eingebaut. Im Normalfall, wenn alle drei Lüfter in Betrieb sind, saugen sie an ihrer Ansaugseite Luft von unten an und blasen sie an ihrer Ausblasseite nach oben aus dem Schaltschrank heraus. Damit bildet sich über den Querschnitt des Schaltschranks hinweg eine weitgehend gleichmäßige Luftströmung von unten nach oben (Hauptströmungsrichtung) aus.

Sei nun beispielsweise der mittlere Lüfter ausgefallen. Der Strömungswiderstand ΔP₁ ist aufgrund der Vielzahl der in den Schaltschrank eingebauten (aber im Bild nicht dargestellten) Baugruppen deutlich größer als der Strömungswiderstand ΔP₂ des ausgefallenen Lüfters. Deshalb werden der linke und rechte Lüfter nun nicht mehr die Luft von unten ansaugen. Es entsteht ein strömungstechnischer Kurzschluss. Der linke und der rechte Lüfter werden nur noch Umluft zwischen Ansaugseite und Ausblasseite erzeugen, wie durch die Strömungspfeile in FIG. 1 dargestellt. Die Baugruppen werden somit nicht mehr durch den Luftstrom gekühlt. Dies führt in der Folge zu einer starken Erhitzung der elektronischen Bauelemente auf den Baugruppen. Dies kann zum Ausfall selbiger führen, mindestens jedoch zur Verringerung ihrer Lebensdauer.

Um dies zu verhindern, wurden in der Vergangenheit den einzelnen Lüftern zugeordnete Klappen oder Lamellen eingesetzt, die einen strömungstechnischen Kurzschluss verhindern können. Die Lösung besteht im Prinzip darin, bei Ausfall eines einzelnen Lüfters dessen Luftkanal bzw. Strömungskanal zu verschließen. Dadurch werden die noch in Betrieb befindlichen Lüfter daran gehindert, ihre Ansaugluft durch diesen Luftkanal zu beziehen. Ein strömungstechnischer Kurzschluss wird somit verhindert. Die Kühlung der Baugruppen ist gewährleistet.

Ein Nachteil dieser durch Schwerkraft oder durch Unterdruck schließenden Klappen ist, dass bei einem Ausfall aller Lüfter, zum Beispiel durch Stromausfall, eine natürliche Konvektion zur Aufrechterhaltung einer Notkühlung nicht mehr möglich ist.

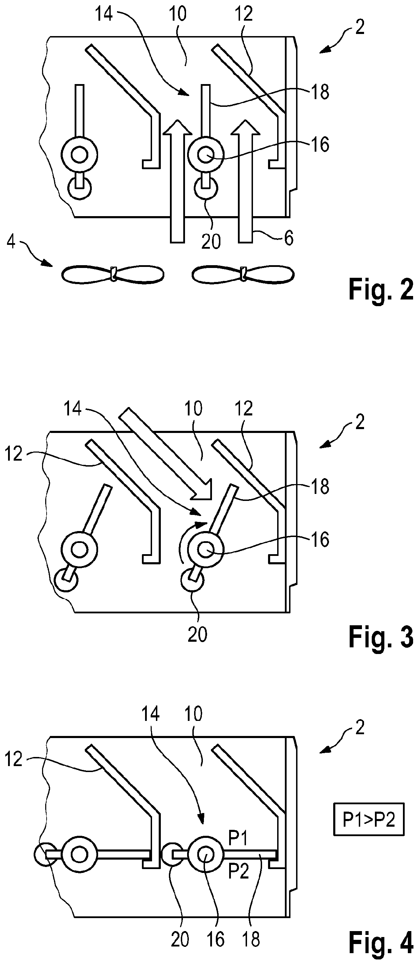

Bei der Lüfteranordnung gemäß DD 253 722 A1 sind die Klappen jeweils derart konstruiert und im Strömungskanal angeordnet, dass sie durch den von den Ventilatoren erzeugten Luftstrom in der Öffnungsstellung gehalten werden und durch einen dem Luftstrom entgegen gerichteten Rückstrom in die Schließstellung gebracht werden. Falls alle Ventilatoren gleichzeitig ausfallen, bleiben die Klappen in ihrer Öffnungsstellung, in der sie sich (mit Winkel α > 90, siehe Fig. 3) an zugehörige Anschläge anlehnen. Damit kann eine natürliche Konvektion durch die Strömungskanäle erfolgen. Dieser Mechanismus funktioniert jedoch nicht, falls die Ventilatoren einer nach dem anderen ausfallen, oder falls die Klappen während eines Stromausfalls durch Vibration oder dergleichen in die Schließstellung fallen. Dann bleiben sie geschlossen und verhindern oder behindern die gewünschte Naturkonvektion.

Der Erfindung liegt die Aufgabe zugrunde, eine Lüfteranordnung der eingangs beschriebenen Art anzugeben, bei der einerseits ein strömungstechnischer Kurzschluss bei Ausfall einzelner Ventilatoren bzw. Lüfter zuverlässig verhindert ist, und bei der andererseits eine Naturzugkonvektion bei Ausfall sämtlicher Lüfter sichergestellt ist. Damit soll insbesondere eine zuverlässige Entwärmung von Schaltschränken in allen vorhersehbaren Betriebssituationen erreicht werden.

Die genannte Aufgabe wird erfindungsgemäß gelöst durch eine Lüfteranordnung mit den Merkmalen des Anspruchs 1.

Demnach ist die jeweilige Klappe derart konstruiert, dass sie im strömungslosen Zustand durch ihr Eigengewicht in die Öffnungsstellung gebracht wird, falls sie vorher geschlossen war.

Das bedeutet, dass die Klappen beim Ausfall sämtlicher Ventilatoren, etwa bei Stromausfall, auf zuverlässige Weise automatisch öffnen und die zugeordneten Strömungskanäle für eine Naturkonvektion freigeben. Selbst wenn eine oder mehrere Klappen zuvor strömungsbedingt oder durch andere Umstände geschlossen waren, öffnen sie in solchen Ausnahmesituationen eigenständig und ohne äußeres Zutun aufgrund der wirksamen Gewichtskraft. Die aus dem Stand der Technik bekannte Schließfunktion in Szenarien mit einem strömungstechnischen Kurzschluss durch die entstehende / einsetzende Druckdifferenz oder Rückströmung, nämlich bei Ausfall einzelner Lüfter, wird nicht beeinträchtigt.

Besonders vorteilhaft ist die Verwendung der beschriebenen Lüfteranordnung in einem Schaltschrank, der beispielsweise die elektrischen und elektronischen Komponenten oder Baugruppen einer verfahrenstechnischen Anlage, einer Werkzeugmaschine oder einer Fertigungseinrichtung aufnimmt. Von besonderem Interesse sind in diesem Zusammenhang Schaltschränke für die leittechnischen Einrichtungen eines Kernkraftwerkes, bei denen auch im Falle eines sogenannten Station Blackout eine rudimentäre Notfallkühlung bzw. Wärmeabfuhr durch Naturzugkonvektion gewährleistet sein soll. Die erfindungsgemäße Lüfteranordnung ist bevorzugt in einer Boden- oder Deckenplatte eines solchen Schaltschrankes angeordnet. Selbstverständlich kann sie auch zur Lüftung und Entwärmung anderer Räume oder Raumbereiche eingesetzt werden.

Für wiederkehrende Prüfungen kann eine Überwachung der Klappen vorgesehen werden. Durch eine geeignete Sensorik in Verbindung mit einer zugehörigen Auswerteeinheit wird die aktuelle Stellung der Klappen erfasst, ausgewertet und ggf. aufgezeichnet. Die Sensoren sollten vorzugsweise berührungslos arbeiten, um keine zusätzliche Reibung bei der Bewegung der Klappen zu verursachen. In der Auswerteeinheit kann die erfasste Klappenstellung mit dem anderweitig (beispielsweise über elektrische Kenngrößen) erfassten Betriebszustand des zugeordneten Ventilators in Beziehung gesetzt werden und ggf. eine Alarmmeldung erzeugt werden.

Weitere die Erfindung betreffende Einzelheiten und Vorteile gehen aus den Unteransprüchen sowie aus der nachfolgenden detaillierten Beschreibung eines Ausführungsbeispiels hervor. Dabei zeigt in vereinfachter und schematischer Darstellung:
- FIG. 1: eine Lüfteranordnung in einem Schaltschrank, wobei die Strömungs-pfeile einen strömungstechnischen Kurzschluss infolge eines ausge-fallenen Lüfters andeuten,
- FIG. 2: einen Ausschnitt aus einer Lüfteranordnung mit einer zugehörigen Klappenmechanik zur Verhinderung strömungstechnischer Kurzschlüsse, hier in einer ersten Betriebsstellung mit geöffneten Klappen,
- FIG. 3: die Lüfteranordnung gemäß FIG. 2 in einer zweiten Betriebsstellung mit sich gerade schließenden Klappen,
- FIG. 4: die Lüfteranordnung gemäß FIG. 2 in einer dritten Betriebsstellung mit geschlossenen Klappen,
- FIG. 5: eine ähnliche Lüfteranordnung wie in FIG. 2 in einem ersten Betriebszustand mit geöffneten Klappen,
- FIG. 6: die Lüfteranordnung aus FIG. 5 in einem zweiten Betriebszustand mit geschlossenen Klappen, und
- FIG. 7: einen Schaltschrank mit einer Lüfteranordnung.

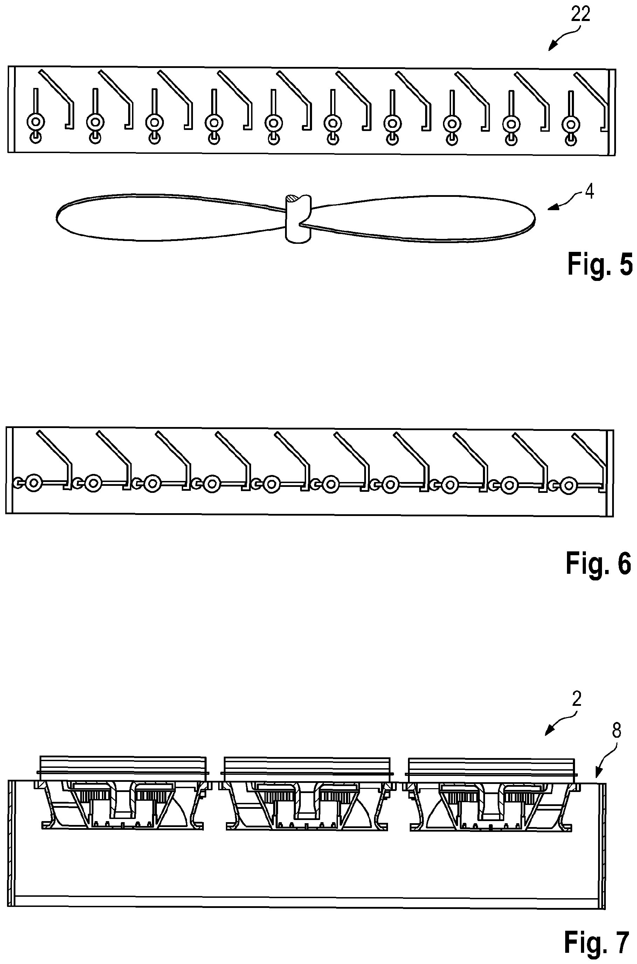

Gleiche oder gleichwirkende Teile sind in allen Figuren mit denselben Bezugszeichen versehen. In FIG. 3 und 4 wurden die in FIG. 2 dargestellten Ventilatoren der einfacheren Darstellung halber weggelassen. Gleiches gilt für den in FIG. 5 dargestellten Ventilator, der in der zugehörigen FIG. 6 weggelassen wurde.

FIG. 2 zeigt einen Schnitt durch eine Lüfteranordnung 2. Die Lüfteranordnung 2 umfasst eine Mehrzahl von nebeneinander in einer horizontalen Ebene angeordneten Ventilatoren 4. Die Ventilatoren 4 können beispielsweise in gleichmäßigen Abständen zueinander in einer Reihe angeordnet sein. Es können mehrere zueinander parallele Reihen vorhanden sein, so dass sich in der Draufsicht ein schachbrettartiges oder gitterartiges Muster ergibt. Auch unregelmäßige Anordnungen sind möglich. Die Ventilatoren 4 sind bevorzugt alle gleichartig aufgebaut und jeweils durch Elektromotoren angetrieben. Die Ventilatoren 4 sind hier schematisch als Axialgebläse dargestellt; es können auch andere Varianten wie etwa Radialgebläse zum Einsatz kommen. Im Normalbetrieb erzeugen die Rotorblätter der Ventilatoren 4 jeweils einen von unten nach oben (= Hauptströmungsrichtung 6) gerichteten Luftstrom. Die einzelnen Teilströme setzen sich zu einem Gesamtstrom zusammen, der beispielsweise zur Entlüftung und Entwärmung eines unterhalb der Ventilatoren 4 befindlichen Raumbereiches dient. Insbesondere kann die Lüfteranordnung 2 gemäß FIG. 7 in eine Deckenplatte eines Schaltschrankes 8, der elektronische Baugruppen aufnimmt, integriert sein.

Jedem Ventilator 4 sind ein oder mehrere Strömungskanäle 10 exklusiv zugeordnet, und zwar in dem Sinne, dass der von dem Ventilator 4 erzeugte Teilstrom im Wesentlichen oder zumindest zu einem großen Teil nur durch genau diesen Strömungskanal 10 oder diese Strömungskanäle 10 hindurchtritt, nicht aber durch die Strömungskanäle 10 der anderen Ventilatoren 4. In FIG. 2 ist eine mögliche Anordnung mit genau einem zugeordneten Strömungskanal 10 je Ventilator 4 dargestellt. Eine andere Variante, bei der je einem Ventilator 4 mehrere Strömungskanäle 10 zugeordnet sind, ist in FIG. 5 dargestellt. Hier muss man sich mehrere derartiger Einheiten mit jeweils einem Ventilator 4 und zugehörigen Strömungskanälen 10 in einer Ebene nebeneinander vorstellen (aus Platzgründen ist nur eine solche Einheit dargestellt).

Die einzelnen Strömungskanäle 10, die entsprechend der vorgesehenen Hauptströmungsrichtung 6 im Wesentlichen vertikal ausgerichtet sind, sind durch geeignete Leitelemente 12 oder Leitflächen zumindest teilweise voneinander abgetrennt. Derartige Leitelemente 12 werden auch als Leitbleche bezeichnet, wenngleich sie nicht notwendigerweise aus Metall bestehen, sondern zum Beispiel aus Kunststoff gefertigt sein können. Gemäß der Darstellung in FIG. 2 sind die Strömungskanäle 10 bevorzugt oberhalb der Ventilatoren 4 angeordnet. Alternativ befinden sich die Ventilatoren 4 innerhalb der zugehörigen Strömungskanäle 10. Insbesondere kann der jeweilige Strömungskanal 10 oder ein Abschnitt davon durch ein die Rotorblätter des Ventilators 4 umschließendes oder einfassendes Gehäuse verwirklicht sein. Zweckmäßigerweise sind alle Strömungskanäle 10 in gleichartiger Weise ausgebildet, und die Anordnung der zugeordneten Ventilatoren 4 ist ebenfalls bevorzugt für alle einzelnen Einheiten gleich. Oberhalb der Strömungskanäle 10 vereinigen sich die einzelnen Teilströme zu einem Gesamtstrom (Lüftungsstrom).

Zur Verhinderung der eingangs im Zusammenhang mit FIG. 1 beschriebenen Situation eines strömungstechnischen Kurzschlusses bei Ausfall einzelner Lüfter ist jeder Strömungskanal 10 mit einer auch als Rückschlagklappe bezeichneten Klappe 14 ausgestattet, mittels derer er bedarfsweise - einzeln und unabhängig von den anderen Strömungskanälen 10 - verschließbar ist.

Bei dem in den Figuren dargestellten Ausführungsbeispiel ist die jeweilige Klappe 14 nach Art einer Pendelklappe ausgebildet. Sie umfasst ein an einer horizontalen Schwenkachse oder Drehachse 16 angelenktes flügelartiges oder lamellenartiges Verschlusselement 18. Die Drehachse 16 befindet sich hier innerhalb des Strömungskanals 10 an dessen unterem Ende. In der Schließstellung ist das Verschlusselement 18 horizontal ausgerichtet und verschließt den Querschnitt des zugehörigen Strömungskanals 10 im Wesentlichen vollständig (FIG. 4). Der Durchtritt von Luft durch den Strömungskanal 10 ist dann blockiert. In der Öffnungsstellung ragt das Verschlusselement 18 in vertikaler Ausrichtung in den Strömungskanal 10 hinein und setzt dem durch den Strömungskanal 10 strömenden Luftstrom durch seinen schmalen Querschnitt einen möglichst geringen Strömungswiderstand entgegen (FIG. 2). Dadurch kann der von dem zugehörigen Ventilator 4 erzeugte Luftstrom bei dieser Klappenstellung im Wesentlichen ungehindert durch den Strömungskanal 10 hindurch strömen.

Die Betätigung oder "Ansteuerung" der jeweiligen Klappe 14 erfolgt hier automatisch und auf rein passive Weise durch die Ausnutzung intrinsischer, ausfallsicherer Kräfte, nämlich der Gewichtskraft einerseits und der durch den Strömungsdruck hervorgerufenen Kraft andererseits. Dazu ist die im Folgenden beschriebene Klappenmechanik vorgesehen.

Wesentlich dabei ist, dass ein mit dem Verschlusselement 18 verbundenes oder in es integriertes Gegengewicht 20 die Klappe im strömungslosen Zustand in die Öffnungsstellung bringt. Dazu sind die Massen und die Hebellängen der beidseits von der Drehachse 16 abstehenden Klappensegmente (Hebelarme) geeignet gewählt. Das Gegengewicht 20 kann auch durch geeignete Gewichtsverteilung in Relation zur Anordnung der Drehachse 16 durch das Verschlusselement 18 selber gebildet sein. Das bedeutet im Ergebnis, dass die Klappe 14 im strömungslosen oder beinahe strömungslosen Zustand zuverlässig von selber durch ihr Eigengewicht öffnet, falls sie vorher geschlossen gewesen sein sollte, und anschließend in der Öffnungsstellung verbleibt. Auch bei Auslenkungen aus der Ruhelage, die durch vorübergehende äußere Störungen erzwungen werden, kehrt die Klappe 14 immer wieder von selber in die Öffnungsstellung zurück. Ein entlang der Hauptströmungsrichtung 6, von unten nach oben gerichteter Luftstrom, wie er im regulären Betrieb der Lüfteranordnung 2 durch den zugehörigen Ventilator 4 aufgeprägt wird, unterstützt die Offenhaltung der Klappe 14.

Zum Schließen der jeweiligen Klappe 14 kommt es lediglich in Situationen mit Strömungs- bzw. Druckverhältnissen, die eine Rückströmung durch den Strömungskanal 10 entgegen der regulären Strömungsrichtung bewirken. Zu diesem Zweck sind die den jeweiligen Strömungskanal 10 begrenzenden Leitelemente 12 an einer Knick- oder Biegestelle gegenüber der Vertikalen abgewinkelt. Durch die schräge Ausrichtung des Strömungskanals 10 in seinem oberen Bereich trifft eine gerade einsetzende / entstehende Rückströmung annähernd senkrecht oder zumindest mit einer senkrechten Komponente auf das Verschlusselement 18 und bewirkt ein Drehmoment in Richtung Schließstellung. Je größer die Schrägstellung des oberen Kanalabschnitts ist, desto größer fällt das Schließmoment aus, desto mehr wird aber auch die Strömung umgelenkt. Bei geeigneter Auslegung der Gewichtsverhältnisse reicht ein kleines Schließmoment, um das durch das Eigengewicht bewirkte Öffnungsmoment zu überwinden und die Klappe 14 in ihre Schließstellung zu bewegen (Drehen / Schwenken in Pfeilrichtung gemäß FIG. 3). Solange der Luftdruck P1 oberhalb der Klappe 14 den Luftdruck P2 darunter überwiegt, bleibt die Klappe 14 sicher in der Schließstellung (FIG. 4).

Damit ergibt sich zusammengefasst folgendes Verhalten:
Im Normalbetrieb der Lüfteranordnung 2 blasen sämtliche Ventilatoren 4 Luft von unten nach oben. Sämtliche Klappen 14 sind geöffnet und werden durch den Luftstrom offen gehalten.

Fällt nun ein einzelner Ventilator 4 aus, bewirkt der Luftstrom, der sich aufgrund des strömungstechnischen Kurzschlusses einstellt, ein Schließen genau dieser Klappe 14. Durch die Arbeit der noch in Betrieb befindlichen Lüfter stellt sich unterhalb der geschlossenen Klappe 14 ein geringerer Druck als oberhalb ein. Dadurch wird die Klappe 14 zuverlässig geschlossen gehalten.

Werden nun alle Lüfter abgeschaltet oder fallen aus, entfällt auch die genannte Druckdifferenz. Das Eigengewicht / Gegengewicht der jeweiligen Klappe 14 bewirkt durch die Schwerkraft ein Öffnen der Klappe 14. Dies gilt für sämtliche Klappen 14. Eine Durchströmung sämtlicher Strömungskanäle 10 durch natürliche Konvektion ist nun möglich. Der in der Regel von unten nach oben gerichtete Konvektionsstrom unterstützt die Offenhaltung der Klappen 14.

Wie bereits erwähnt, kann in einer möglichen Realisierung gemäß FIG. 2 einem Ventilator 4 genau ein Strömungskanal 10 mit einer Klappe 14 zugeordnet sein. Es kann aber auch wie in FIG. 5 einem Ventilator 4 eine Mehrzahl von Strömungskanälen 10 mit jeweils einer Klappe 14 zugeordnet sein. Die einem bestimmten Ventilator 4 zugeordneten Klappen 14 sind dann in ihrer Funktion zwar prinzipiell unabhängig voneinander, werden aber in der Regel gemeinsam in der Öffnungsstellung (FIG. 5) oder in der Schließstellung (FIG. 6) sein, weil die Strömungsverhältnisse für sie alle gleich sind. Diese Variante besitzt den Vorteil, dass kleinere und leichtere Klappen 14 mit einer geringen Trägheit verwendet werden können.

FIG. 7 zeigt die erfindungsgemäße Lüfteranordnung 2 in einer Deckenplatte eines Schaltschranks 8. Die Details der jeweiligen Klappenmechanik (Strömungskanäle und Klappen) wurden in dieser Darstellung allerdings weggelassen. Die Klappenmechanik ist hier jeweils in das Gehäuse der Ventilatoren 4 integriert. Es ist aber auch möglich, dass die Klappenmechaniken insgesamt eine bauliche Einheit bilden, nämlich eine Lüfterklappenanordnung 22, die auf einen Ventilator 4 oder auf eine bestehende Ventilatoranordnung montierbar ist (vgl. FIG. 5).

### Bezugszeichenliste

- 2: Lüfteranordnung
- 4: Ventilator
- 6: Hauptströmungsrichtung
- 8: Schaltschrank
- 10: Strömungskanal
- 12: Leitelement
- 14: Klappe
- 16: Drehachse
- 18: Verschlusselement
- 20: Gegengewicht
- 22: Lüfterklappenanordnung

## Patentansprüche

1. Lüfteranordnung (2) mit einer Mehrzahl von parallel zueinander angeordneten und zur Erzeugung eines Luftstromes entlang einer gemeinsamen Hauptströmungsrichtung (6) ausgelegten Ventilatoren (4), wobei
• jedem Ventilator (4) mindestens ein Strömungskanal (10) zugeordnet ist,
• der jeweilige Strömungskanal (10) mit einer Klappe (14) versehen ist, die zwischen einer Öffnungsstellung und einer Schließstellung schwenkbar ist,
• die jeweilige Klappe (14) derart konstruiert und im Strömungskanal (10) angeordnet ist, dass sie durch den Luftstrom in der Öffnungsstellung unterstützt wird und durch einen dem Luftstrom entgegen gerichteten Rückstrom in die Schließstellung gebracht wird,
• die jeweilige Klappe (14) derart konstruiert ist, dass sie im strömungslosen Zustand durch ihr Eigengewicht in die Öffnungsstellung gebracht wird,
• die Hauptströmungsrichtung (6) im Wesentlichen vertikal von unten nach oben ausgerichtet ist,
**dadurch gekennzeichnet, dass**
• die Strömungskanäle (10) durch Leitelemente (12) voneinander abgetrennt sind,
• das jeweilige Leitelement (12) einen vertikal ausgerichteten Abschnitt und einen davon abknickenden, schräg ausgerichteten Abschnitt aufweist, wobei der schräg ausgerichtete Abschnitt oberhalb des vertikal ausgerichteten Abschnitts liegt und wobei die Drehachse (16) der jeweiligen Klappe (14) etwa auf Höhe des vertikalen Abschnitts angeordnet ist.

2. Lüfteranordnung (2) nach Anspruch 1, wobei die jeweilige Klappe (14) als Pendelklappe ausgebildet ist.

3. Lüfteranordnung (2) nach Anspruch 1 oder 2, wobei die jeweilige Klappe (14) um eine horizontale Drehachse (16) schwenkbar ist.

4. Lüfteranordnung (2) nach einem der Ansprüche 1 bis 3, wobei die jeweilige Klappe (14) ein flügelartiges Verschlusselement (18) und ein Gegengewicht (20) aufweist.

5. Lüfteranordnung (2) nach Anspruch 4, wobei das jeweilige Verschlusselement (18) in der Schließstellung horizontal ausgerichtet ist.

6. Lüfteranordnung 2 nach Anspruch 4 oder 5, wobei das jeweilige Verschlusselement (18) in der Öffnungsstellung vertikal ausgerichtet ist.

7. Lüfteranordnung (2) nach einem der Ansprüche 1 bis 6, wobei alle Klappen (14) gleichartig ausgebildet sind.

8. Lüfteranordnung (2) nach einem der Ansprüche 1 bis 7, wobei alle Strömungskanäle (10) gleichartig ausgebildet sind.

9. Lüfteranordnung (2) nach einem der Ansprüche 1 bis 8, wobei alle Klappen (14) gleichartig in den Strömungskanälen (10) angeordnet sind.

10. Schaltschrank (8) mit einer Lüfteranordnung (2) nach einem der Ansprüche 1 bis 9.

## Claims

1. A fan arrangement (2) with a plurality of ventilators (4), which are arranged parallel to one another and are designed to generate an air flow along a common main flow direction (6), wherein
• at least one flow channel (10) is assigned to each ventilator (4),
• the respective flow channel (10) is provided with a flap (14), which can be swiveled between an open position and a closed position,
• the respective flap (14) is constructed and arranged in the flow channel (10), in such a manner that it is supported by the air flow in the open position and is brought into the closed position by a reverse flow opposing the air flow,
• the respective flap (14) is constructed in such a manner that it is brought into the open position due to its intrinsic weight when no air is flowing,
• the main flow direction (6) is oriented substantially vertically from the bottom to the top,
**characterized in that**
• the flow channels (10) are separated from one another by guide elements (12),
• the respective guide element (12) has a vertically oriented section and an obliquely oriented section, which bends away therefrom, wherein the obliquely oriented section is located above the vertically oriented section and wherein the axis of rotation (16) of the respective flap (14) is arranged approximately at the height of the vertical section.

2. The fan arrangement (2) according to claim 1, wherein the respective flap (14) is designed as a pendulum flap.

3. The fan arrangement (2) according to claim 1 or 2, wherein the respective flap (14) can be swiveled about a horizontal axis of rotation (16).

4. The fan arrangement (2) according to any one of claims 1 to 3, wherein the respective flap (14) has a wing-like closure element (18) and a counterweight (20).

5. The fan arrangement (2) according to claim 4, wherein the respective closure element (18) is horizontally oriented in the closed position.

6. The fan arrangement (2) according to claim 4 or 5, wherein the respective closure element (18) is vertically oriented in the open position.

7. The fan arrangement (2) according to any one of claims 1 to 6, wherein all flaps (14) are identically designed.

8. The fan arrangement (2) according to any one of claims 1 to 7, wherein all flow channels (10) are identically designed.

9. The fan arrangement (2) according to claims 1 to 8, wherein the flaps (14) are arranged in the flow channels (10) in the same way.

10. A control cabinet (8) with a fan arrangement (2) according to any one of claims 1 to 9.

## Revendications

1. Ensemble ventilateur (2) avec une pluralité de ventilateurs (4) disposés parallèlement les uns aux autres et conçus pour générer un flux d'air le long d'une direction d'écoulement principale (6) commune,
• au moins un canal d'écoulement (10) étant affecté à chaque ventilateur (4),
• le canal d'écoulement (10) respectif étant muni d'un volet (14) qui peut pivoter entre une position d'ouverture et une position de fermeture,
• le volet (14) respectif étant construit et disposé dans le canal d'écoulement (10) de telle sorte que qu'il est supporté par le flux d'air dans la position d'ouverture et amené dans la position de fermeture par un flux de retour dirigé à l'opposé du flux d'air,
• le volet (14) respectif étant construit de telle sorte que, dans l'état sans écoulement, il est amené dans la position d'ouverture par son poids propre,
• la direction d'écoulement principale (6) étant orientée essentiellement verticalement du bas vers le haut,
**caractérisé en ce que**
• les canaux d'écoulement (10) sont séparés les uns des autres par des éléments de guidage (12),
• l'élément de guidage (12) respectif comporte un tronçon orienté verticalement et un tronçon orienté obliquement et formant un coude avec le précédent, le tronçon orienté obliquement étant situé au-dessus du tronçon orienté verticalement, et l'axe de rotation (16) du volet (14) respectif étant disposé sensiblement à la hauteur du tronçon vertical.

2. Ensemble ventilateur (2) selon la revendication 1, le volet (14) respectif étant constitué en tant que volet oscillant.

3. Ensemble ventilateur (2) selon la revendication 1 ou 2, le volet (14) respectif pouvant pivoter autour d'un axe de rotation (16) horizontal.

4. Ensemble ventilateur (2) selon l'une des revendications 1 à 3, le volet (14) respectif comportant un élément d'obturation (18) du type ailette et un contrepoids (20).

5. Ensemble ventilateur (2) selon la revendication 4, l'élément d'obturation (18) respectif étant orienté horizontalement dans la position de fermeture.

6. Ensemble ventilateur (2) selon la revendication 4 ou 5, l'élément d'obturation (18) respectif étant orienté verticalement dans la position d'ouverture.

7. Ensemble ventilateur (2) selon l'une des revendications 1 à 6, tous les volets (14) étant constitués de façon identique.

8. Ensemble ventilateur (2) selon l'une des revendications 1 à 7, tous les canaux d'écoulement (10) étant constitués de façon identique.

9. Ensemble ventilateur (2) selon l'une des revendications 1 à 8, tous les volets (14) étant disposés de façon identique dans les canaux d'écoulement (10).

10. Armoire électrique (8) avec un ensemble ventilateur (2) selon l'une des revendications 1 à 9.
